# EUROPÄISCHE PATENTANMELDUNG

(11) **EP 1 662 577 A1**
(43) Veröffentlichungstag der Anmeldung: **31.05.2006**
(21) Anmeldenummer: 05025517.3
(22) Anmeldetag: 23.11.2005
(51) Int. Cl.: H01L 29/423, H01L 29/78

(54) **MOS Transistor mit reduziertem Kink-Effekt und Verfahren zur Herstellung**

(30) Priorität: 25.11.2004 DE 102004058468
(71) Anmelder: ATMEL Germany GmbH, 74072 Heilbronn (DE)
(72) Erfinder: Dudek, Volker, Dr., 74336 Brackenheim (DE); Schwantes, Stefan, Dr., 74080 Heilbronn (DE)

(57) **Zusammenfassung**

Vorgestellt wird ein lateraler MOS-Transistor (38) mit einem Kanalbereich (12), der eine durch dielektrisch gefüllte Gräben (18, 20) begrenzte Kanalweite (W) aufweist und der durch ein Gate-Dielektrikum (22) bedeckt wird, dessen Schichtdicke über der Kanalweite (W) variiert. Der Transistor zeichnet sich dadurch aus, dass eine äußere Schichtdicke (32), die das Gate-Dielektrikum (22) über Übergängen des Kanalbereichs (12) zu den dielektrisch gefüllten Gräben (18, 20) besitzt, größer ist als eine innere Schichtdicke (34), die das Dielektrikum (22) über einem zentralen Teil (36) des Kanalbereichs (12) besitzt. Ferner wird ein Verfahren zur Herstellung eines solchen MOS-Transistors (38) vorgestellt.

## Beschreibung

Die Erfindung betrifft einen MOS-Transistor mit einem Kanalbereich, der eine durch dielektrisch gefüllte Gräben begrenzte Kanalweite aufweist und der durch ein Gate-Dielektrikum bedeckt wird, dessen Schichtdicke über der Kanalweite variiert.

Ferner betrifft die Erfindung ein Verfahren zur Herstellung eines MOS-Transistors mit einem Kanalbereich, der eine durch dielektrisch gefüllte Gräben begrenzte Kanalweite aufweist und der in einem Zwischenschritt des Verfahrens mit einem Gate-Dielektrikum bedeckt wird, dessen Schichtdicke über der Kanalweite variiert.

Ein solcher MOS-Transistor und ein solches Herstellungsverfahren sind per se bekannt. Bei den bekannten MOS-Transistoren stellt sich an Rändern des aktiven Bereichs eine verringerte Dicke der Gate-Schicht ein. Dies wird weiter unten noch näher erläutert. Übliche MOS Transistoren vom Anreicherungstyp weisen eine MOS-Diode aus einer Schichtfolge von hochleitfähiger Gate-Elektrode (z.B. Metall), dielektrischer Gate-Schicht (z.B. Oxid) und Halbleiterschicht (semiconductor) eines ersten Leitfähigkeitstyps auf. Die MOS-Diode grenzt an Halbleiterschichten eines zweiten Leitfähigkeitstyps, so dass sie durch zwei pn-Übergänge begrenzt wird. Auf der einen Seite der MOS-Diode wird ein hochdotiertes Source-Gebiet und auf der anderen Seite ein hochdotiertes Drain-Gebiet im Halbleitermaterial des zweiten Leitfähigkeitstyps erzeugt. Beim Anlegen einer Spannung zwischen Source-Gebiet und Drain-Gebiet sperrt einer der beiden pn-Übergänge, die die MOS-Diode begrenzen, sodass die zwischen Drain-Gebiet und Source-Gebiet anliegende Spannung keinen Strom durch die MOS-Diode treiben kann. Erst wenn durch ein ausreichend hohes Gate-Elektroden-Potential eine Inversionsschicht an der Halbleiter/Dielektrikums-Grenzfläche der MOS-Diode erzeugt wird, verschwindet der vorher sperrende pn-Übergang im Querschnitt der auch als Kanal bezeichneten Inversionsschicht und die Spannung zwischen Drain-Gebiet und Source-Gebiet treibt einen Strom durch die MOS-Diode.

Die MOS-Diode besitzt eine Fläche, die durch das Produkt aus Kanallänge und Kanalweite des Kanalbereichs definiert ist. Dabei wird unter der Kanallänge der Abstand der genannten pn-Übergänge und unter der Kanalweite die Ausdehnung des Kanalbereichs parallel zu den pn-Übergängen verstanden. Einzelne MOS-Transistoren werden in einer Integrierten Schaltung durch Feldoxid voneinander isoliert. Das Feldoxid kann mittels einer lokalen Oxidation (LOCOS = local oxidation of silicium) oder in Form von dielektrisch gefüllten Grabenstrukturen erzeugt werden. Solche Grabenstrukturen werden bekanntlich durch einen STI-Prozess (STI = shallow trench isolation) erzeugt. Die STI-Technik ermöglicht im Vergleich mit der LOCOS-Technik eine höhere Packungsdichte der Bauelemente und wird daher bei hoher Integrationsdichte bevorzugt.

Die Potentialdifferenz zwischen Source-Gebiet und Gate-Elektrode, bei der die Inversion deutlich in Erscheinung tritt (strong inversion), wird bekanntlich als Schwellenspannung bezeichnet. Im Sub-Schwellenspannungsbereich verläuft eine ideale Kennlinie des über der Gate-Spannung aufgetragenen Drain-Stroms exponentiell, also bei logarithmischer Auftragung des Drain-Stroms linear. MOS-Transistoren, die in hochsensitiven Analogschaltungen eingesetzt werden, sollen diese Linearität möglichst genau zeigen. Eine Abweichung von der exponentiellen Abhängigkeit macht sich in der logarithmisch aufgetragenen Kennlinie als Knick bemerkbar, der in der englischsprachigen Fachliteratur auch als "hump" oder "kink" bezeichnet wird. Dieser "Kink"-Effekt kann so ausgeprägt sein, dass die davon betroffenen MOS-Transistoren für hochsensitive Analogschaltungen nicht verwendbar sind. Der Kink-Effekt tritt in der Regel nur in Verbindung mit STI-Oxiden, nicht aber in Verbindung mit LOCOS-Isolierungen auf.

Vor diesem Hintergrund besteht die Aufgabe der Erfindung in der Angabe eines mit hohen Packungsdichten integrierbaren MOS-Transistors, der keinen störenden Kink-Effekt zeigt. Ferner besteht eine weitere Aufgabe der Erfindung in der Angabe eines Verfahrens zur Herstellung eines solchen Transistors.

Diese Aufgabe wird bei einem Transistor der eingangs genannten Art dadurch gelöst, dass eine erste Schichtdicke, die das Gate-Dielektrikum über Übergängen des Kanalbereichs zu den dielektrisch gefüllten Gräben besitzt, größer ist als eine zweite Schichtdicke, die das Dielektrikum über einem zentralen Teil des Kanalbereichs besitzt.

Ferner wird diese Aufgabe bei einem Verfahren der eingangs genannten Art dadurch gelöst, dass der Schritt des Bedeckens des Kanalbereichs mit dem Gate-Dielektrikum einen Schritt zur Erzeugung einer dielektrischen Schicht über dem Kanalbereich, einen Schritt zur lithografischen Unterscheidung eines zentralen Teils des Kanalbereichs von peripheren Teilen des Kanalbereichs an Übergängen zu den dielektrischen Gräben, und einen Schritt zur Erzeugung unterschiedlicher Schichtdicken des Gate-Dielektrikums auf den lithografisch unterschiedenen Teilen des Kanalbereichs aufweist, bei dem sich eine über den peripheren Teilen einstellende erste Schichtdicke größer ist als eine sich über dem zentralen Teil einstellende zweite Schichtdicke des Gate-Dielektrikums.

Durch diese Merkmale wird die Aufgabe der Erfindung vollkommen gelöst. Dabei basiert die Erfindung auf der Erkenntnis, dass der störende Kink-Effekt durch eine unerwünschte Abnahme der Dicke von Gate-Dielektrika an der Grenze zwischen Oxidfüllungen flacher Gräben und aktiven Bereiche von MOS-Dioden der MOS-Transistoren verursacht wird. Die Abnahme der Dicke kommt dadurch zustande, dass vor der Erzeugung der dielektrischen Gate-Schicht mehrfach Dotierstoffe in aktive Bereiche späterer MOS-Transistoren implantiert werden. Vor solchen Implantationen erfolgt in der Regel eine Belegung der Waferoberfläche mit Streuoxiden, die nach jeder Implantation wieder durch selektiv auf Oxid wirkende Reinigungsschritte entfernt werden müssen. Bei solchen selektiv auf Oxid wirkenden Reinigungsschritten wird aus den meist mit Oxid als Dielektrikum gefüllten Grabenstrukturen sukzessive mehr Material abgetragen als aus dem aktiven Bereich. Als Folge bilden sich an Übergängen der Grabenstrukturen zu aktiven Bereichen abgerundete Stufen oder Kanten aus, die beim anschließenden Belegen der Waferoberfläche mit einem Gate-Dielektrikum schwächer mit Material belegt werden als waagerechte Bereiche.

Die im Kantenbereich dünnere Gate-Schicht schwächt im späteren Betrieb den Durchgriff des Feldes der Gate-Elektrode in das darunter liegende Halbleitermaterial entsprechend weniger stark ab als die in waagerechten, zentralen Bereichen des aktiven Materials dickere Gate-Schicht. Unterhalb der dünnen Gate-Schichtbereiche herrschen daher größere elektrische Felder im aktiven Halbleitermaterial der MOS-Diode, was die Inversion unter den dünnen Gate-Schichtbereichen früher einsetzen lässt als in zentralen Bereichen des aktiven Materials. Das gesamte Bauelement verhält sich daher wie eine Parallelschaltung mehrerer MOS-Transistoren mit unterschiedlichen Schwellenspannungen und damit unterschiedlichen Kennlinien. Die resultierende Überlagerung der Kennlinien führt zu dem weiter oben genannten störenden Knick (Kink) in der Kennlinie des gesamten Bauelements.

Dadurch, dass die Erfindung sowohl in ihren Vorrichtungsaspekten als auch in ihren Verfahrensaspekten an den Übergängen vergrößerte Schichtdicken des Gate-Dielektrikums vorsieht, kommt es nicht zu der eher einsetzenden Inversion in Randbereichen des aktiven Materials der MOS-Diode. Als Folge wird der störende Kink-Effekt durch Beseitigung seiner Ursache vollständig eliminiert.

Mit Blick auf Ausgestaltungen des Verfahrens ist bevorzugt, dass der Schritt zur Erzeugung einer dielektrischen Schicht über dem Kanalbereich einen Schritt eines nicht-selektiven Erzeugens einer ersten Dicke der dielektrischen Schicht aufweist.

Das nichtselektive Erzeugen der dielektrischen Schicht wirkt zunächst ausgleichend auf Unebenheiten der Struktur, wie sie zum Beispiel aus den genannten Gründen an den Übergängen aktiver Bereiche zu dielektrisch gefüllten Grabenstrukturen auftreten.

Bevorzugt ist auch, dass der Schritt des nicht-selektiven Erzeugens der ersten Dicke einen Schritt eines Aufwachsens einer ONO-Schicht aufweist.

Unter einer ONO-Schicht versteht man eine Schichtfolge aus einer ersten Oxidteilschicht, einer Nitridschicht und einer zweiten Oxidteilschicht. Durch diese Schichtfolge ergibt sich ein sogenanntes ONO (Oxid-Nitrid-Oxid)-Mehrschichtdielektrikum, das sich durch eine besonders hohe Durchbruchfeldstärke auszeichnet. Die ONO-Schichtfolge zeigt darüber hinaus Ausheileffekte von Dünnstellen oder Löchern in einer der Teilschichten was letztlich ein defektarmes Gate-Dielektrikum mit hohem Isolationswiderstand und einer Dielektrizitätszahl führt, die weit über der von Siliziumdioxid liegt.

Ferner ist bevorzugt, dass eine Oxidteilschicht der ONO-Schicht durch Abscheiden eines TEOS-Oxides gebildet wird.

TEOS ist die Abkürzung für Tetraethylorthosilikat. Aus dieser Verbindung entsteht bei mittleren Temperaturen (bis ca. 700° C) durch Zersetzung Siliziumdioxid. Bei diesem Prozess, der auch als TEOS-Pyrolyse bezeichnet wird, entstehen hochwertige Oxidfilme, die sich zum Beispiel durch eine hohe Durchbruchfeldstärke und eine konforme Kantenbedeckung auszeichnen.

Eine weitere bevorzugte Ausgestaltung zeichnet sich durch einen Lithografieschritt aus, in dem auf der dielektrischen Schicht eine Maske erzeugt wird und über einem zentralen Teil des Kanalbereichs geöffnet wird.

Die Maske deckt hier also den mit einer dielektrischen Schicht bedeckten Übergang zwischen einem aktiven Bereich und den dielektrischen Randbereichen ab. Daher kann der zentrale Bereich ohne unerwünschte Einflüsse auf die abgedeckten Randbereiche modifiziert werden.

Bevorzugt ist auch, dass die dielektrische Schicht in den geöffneten Bereichen durch einen Ätzschritt entfernt wird.

Dadurch kann eine spätere Bildung einer dielektrischen Gate-Schicht über dem zentralen Teil des Kanalbereichs in definierter Weise erfolgen, ohne dass die Eigenschaften der Gate-Schicht durch Reste der vorher nichtselektiv erzeugten dielektrischen Schicht beeinflusst werden.

Eine weitere Ausgestaltung zeichnet sich dadurch aus, dass innerhalb der geöffneten Bereiche eine dielektrische Schicht einer zweiten Dicke erzeugt wird, die kleiner als die erste Dicke ist.

Diese Schicht bildet die genannte Gate-Schicht. Dadurch, dass ihre Dicke kleiner als die erste Dicke ist, ergibt sich an den Übergängen insgesamt der erwünschte Anstieg der Gesamtdicke dielektrischer Schichten, der den Kink-Effekt vermeidet.

Alternativ ist bevorzugt, dass der Schritt zur Erzeugung einer dielektrischen Schicht über dem Kanalbereich einen Schritt eines nicht-selektiven Erzeugens einer späteren inneren Dicke der dielektrischen Schicht aufweist.

Im Rahmen dieser Ausgestaltung schließt sich zunächst ein Lithografieschritt an, in dem auf der dielektrischen Schicht eine Maske erzeugt wird, die außerhalb eines zentralen Teils des Kanalbereichs geöffnet ist. In einem weiteren Schritte wird die Dicke der dielektrischen Schicht in geöffneten Bereichen der Maske auf den Wert der äußeren Dicke vergrößert.

Die Maske deckt also den zentralen Teil des Kanalbereichs ab, so dass Ränder des Kanalbereichs ohne unerwünschte Einflüsse auf den zentralen Teil modifiziert werden können. Durch die Vergrößerung der Dicke der dielektrischen Schicht in den geöffneten Bereichen wird die sonst zu erwartende Verringerung der Schichtdicke beim Übergang von aktiven Bereichen auf dielektrisch gefüllte Grabenstrukturen ausgeglichen oder überkompensiert.

Weitere Vorteile ergeben sich aus der Beschreibung und den beigefügten Figuren.

Es versteht sich, dass die vorstehend genannten und die nachstehend noch zu erläuternden Merkmale nicht nur in der jeweils angegebenen Kombination, sondern auch in anderen Kombinationen oder in Alleinstellung verwendbar sind, ohne den Rahmen der vorliegenden Erfindung zu verlassen.

### Zeichnungen

Ausführungsbeispiele der Erfindung sind in den Zeichnungen dargestellt und werden in der nachfolgenden Beschreibung näher erläutert. Es zeigen, jeweils in schematischer Form:
- Fig. 1: schematisch eine noch unvollständige Struktur eines MOS-Transistors mit einem Drain-Gebiet, einem Source-Gebiet, einem Kanalbereich und aufgebrochen dargestellter Gate-Elektrode und Gate-Schicht;
- Fig. 2: einen Schnitt durch einen MOS-Transistor mit vollständiger Gate-Elektrode und dielektrischer Gate-Schicht, wie sie sich beim Stand der Technik ergibt;
- Fig. 3: einen Schnitt durch einen MOS-Transistor mit jeweils vollständiger Gate-Elektrode und dielektrischer Gate-Schicht, wie er sich als Ausführungsbeispiel der Erfindung ergibt,
- Fig. 4: Kennlinien der MOS-Transistoren aus den Figuren 2 und 3;
- Fig. 5: eine erste Alternative einer Verfahrensschrittfolge zur Herstellung einer Struktur nach Fig. 3; und
- Fig. 6: eine zweite Alternative einer Verfahrensschrittfolge zur Herstellung einer Struktur nach Fig. 3.

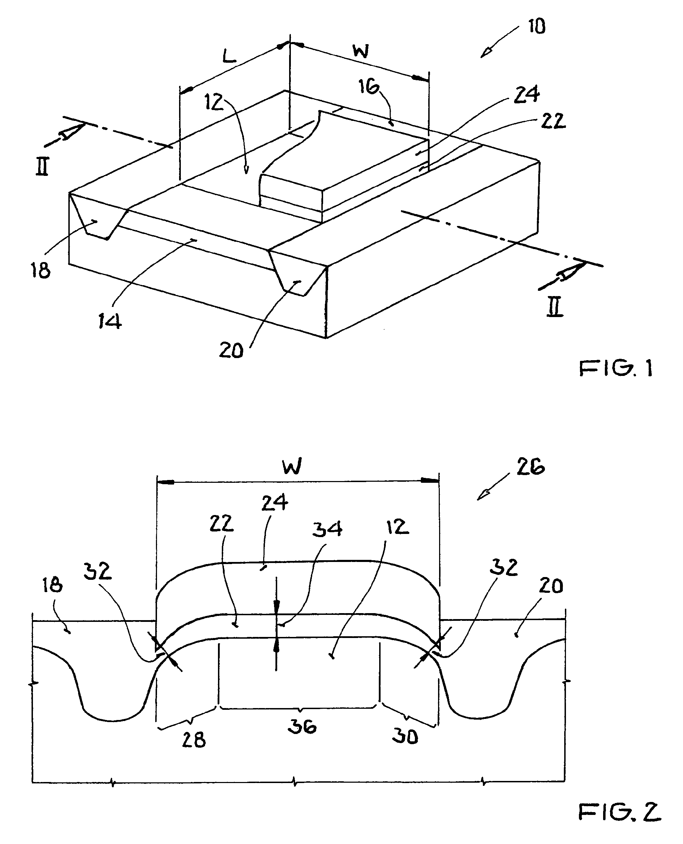

Figur 1 zeigt einen MOS-Transistor 10 mit einem Kanalbereich 12, der sich zwischen einem Source-Gebiet 14 und einem Drain-Gebiet 16 mit einer Länge L erstreckt. Eine Weite W des Kanalbereichs 12 wird durch den Abstand dielektrisch gefüllter Grabenstrukturen 18 und 20 definiert. Source-Gebiet 14 und Drain-Gebiet 16 sind jeweils so dotiert, dass sie einen zum Leitfähigkeitstyp des Kanalbereichs 12 entgegengesetzten Leitfähigkeitstyp besitzen. Der Kanalbereich 12 ist mit einer dielektrischen Gate-Schicht 22 bedeckt, auf der sich eine hoch leitfähige Gate-Elektrode 24 erstreckt.

Die dielektrische Gate-Schicht 22 besteht typischerweise aus einem Oxid und/oder Nitrid des Halbleitermaterials des Kanalbereichs 12. Die hoch leitfähige Gate-Elektrode 24 kann z. B. als Metallschicht oder als hoch dotierte Polysiliziumschicht realisiert sein. Sowie die dielektrische Gate-Schicht 22 als auch die Gate-Elektrode 24 sind in der Figur 1 nur unvollständig dargestellt, um die Schichtfolge aus Kanalbereich 12, dielektrischer Gate-Schicht 22 und Gate-Elektrode 24, also die MOS-Diode des MOS-Transistors 10 zu veranschaulichen.

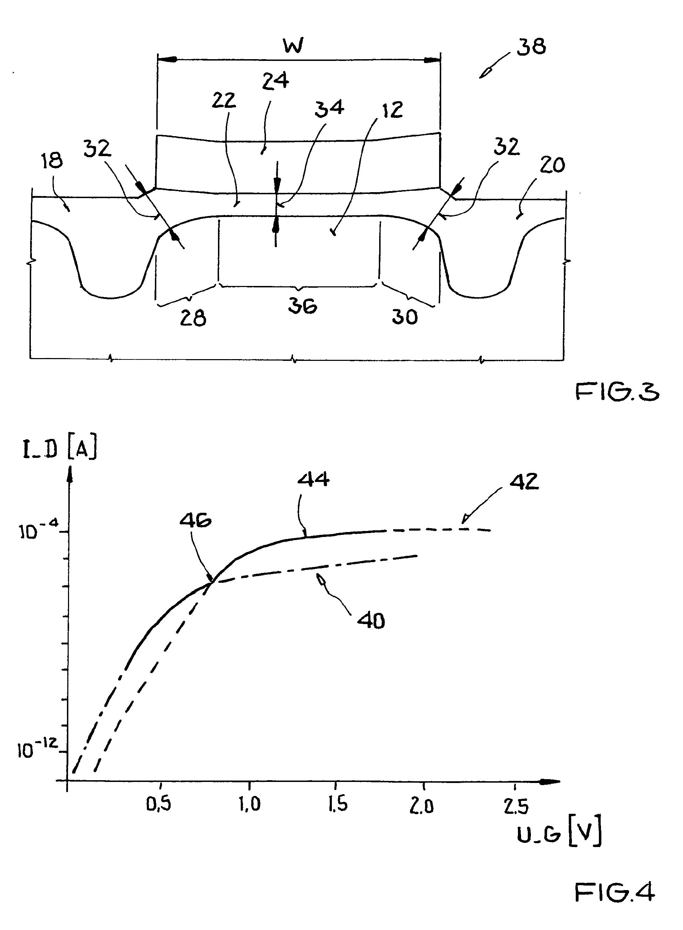

Figur 2 zeigt einen Schnitt durch einen MOS-Transistor 26 aus dem Stand der Technik entlang einer Linie, die wie die Linie II in Figur 1 verläuft und den Kanalbereich 12 längs seiner Weite W und quer zu seiner Länge L schneidet. Neben dem Kanalbereich 12 weist der MOS-Transistor 26 der Figur 2 sämtliche bereits in Zusammenhang mit der Figur 1 erläuterten Elemente 14 bis 24 auf, wobei das Source-Gebiet 14 und das Drain-Gebiet 16 aus der Figur 1 außerhalb der Schnittlinie liegen und daher in der Figur 2 nicht dargestellt sind. Wie eingangs erwähnt, kommt es bei bekannten MOS-Transistoren, deren Kanalweite durch STI-Gräben begrenzt wird, zu einer Variation der Schichtdicke der Gate-Schicht 22 über der Kanalweite W. Dabei stellt sich über peripheren Teilen 28, 30 des Kanalbereichs 12 eine erste Schichtdicke 32 ein, die kleiner als eine zweite Schichtdicke 34 über einem zentralen Teil 36 des Kanalbereichs 12 ist. Es ist die vergleichsweise geringe erste Schichtdicke 32 über den peripheren Teilen 28, 30 des Kanalbereichs 12, die dort zu einem früheren, d. h. bei kleinerem Gate-Potential einsetzenden Inversion in den peripheren Teilen 28, 30 des Kanalbereichs 12 führt. Die damit verbundenen peripheren Leckströme verursachen den störenden "Kink"-Effekt.

Figur 3 zeigt einen Schnitt durch einen verbesserten MOS-Transistor 38 entlang einer Linie, die wie die Linie II in Figur 1 den Kanalbereich 12 längs seiner Weite W und quer zu seiner Länge L schneidet. Auch der MOS-Transistor 38 weist die in Zusammenhang mit der Figur 1 erläuterten Elemente 12 bis 24 auf. Allerdings unterscheidet sich der verbesserte MOS-Transistor 38 von dem bekannten MOS-Transistor 26 aus der Figur 2 durch erste Schichtdicken 32 der Gate-Schicht 22 über peripheren Teilen 28, 30 des Kanalbereichs 12, die größer sind als die zweite Schichtdicke 34 der Gate-Schicht 22 über dem zentralen Teil 36 des Kanalbereichs 12. Dadurch wird ein verfrühtes Einsetzen der Inversion in den peripheren Teilen 28 und 30 vermieden, was die Ursache des "Kink"-Effektes beseitigt.

Figur 4 zeigt Kennlinien des Drain-Stroms I_D über der Gate-Spannung U_G. Dabei ist der Drain-Strom I_D logarithmisch über U_G aufgetragen, so dass sich bei der im Sub-Schwellenspannungsbereich herrschenden exponentiellen Abhängigkeit des Drain-Stroms I_D von der Gate-Spannung U_G ein näherungsweise lineares Verhalten ergibt. Im Fall der strichpunktierten Kennlinie 40 setzt der Anstieg des Drain-Stroms I_D bereits bei kleineren Gate-Spannungen U_G ein als bei der gestrichelten Kennlinie 42. Die gestrichelte Kennlinie 40 spiegelt daher das Leckstromverhalten der peripheren Teile 28, 30 des Kanalbereichs 12 eines bekannten MOS-Transistors 26 aus Figur 2 wider. Die gestrichelte Kennlinie 42 gehört dagegen zu dem zentralen Teil 36 des Kanalbereichs 12, dessen Leitfähigkeit erst bei größeren Gate-Spannungen U_G einsetzt.

Bei größeren Gate-Spannungen U_G dominiert der Einfluss des zentralen Teils 36 des Kanalbereichs 12, während bei kleinen Gate-Spannungen U_G die peripheren Teile 28, 30 des Kanalbereichs 12 das Verhalten des Transistors dominieren. Aufgrund der exponentiellen Abhängigkeit spielen die jeweils nicht dominanten Beiträge in der logarithmischen Darstellung der Figur 4 nur vernachlässigbare Rollen. Daher ergibt sich die Gesamtkennlinie eines bekannten MOS-Transistors 26 durch die durchgezogene Linie 44 in der Figur 4, die im Punkt 46 den störenden Knick aufweist.

Im Gegensatz zu dem bekannte MOS-Transistor 26 aus der Figur 2 tragen die peripheren Teile 28, 30 beim verbesserten MOS-Transistor 38 aus der Figur 3 nicht oder nur in einem vernachlässigbaren Ausmaß zum Strom durch den Kanalbereich 12 bei. Beim MOS-Transistor 38 aus der Figur 3 wird die I_D-Abhängigkeit von der Gate-Spannung U_G daher von dem zentralen Teil 36 des Kanalbereichs 12 dominiert, dessen Kennlinie der gestrichelten Kennlinie 42 aus der Figur 4 ohne Einflüsse einer strichpunktierten Kennlinie 40 entspricht. Die gestrichelte Kennlinie 42 wird daher im Fall des MOS-Transistors 38 aus der Figur 3 nicht durch Leckstromeinflüsse verfälscht und weist daher weder im Punkt 46 noch in anderen Kennlinienpunkten einen störenden Knick auf. In der Fig. 4 erhält man die Kennlinie des verbesserten Transistors 38 qualitativ durch Weglassen der Kennlinie 40.

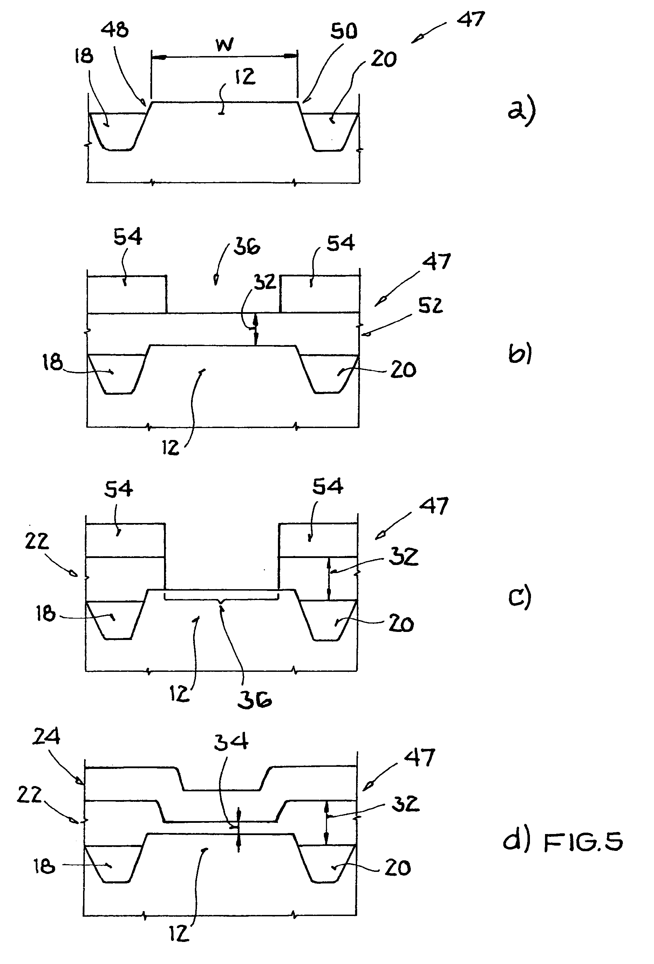

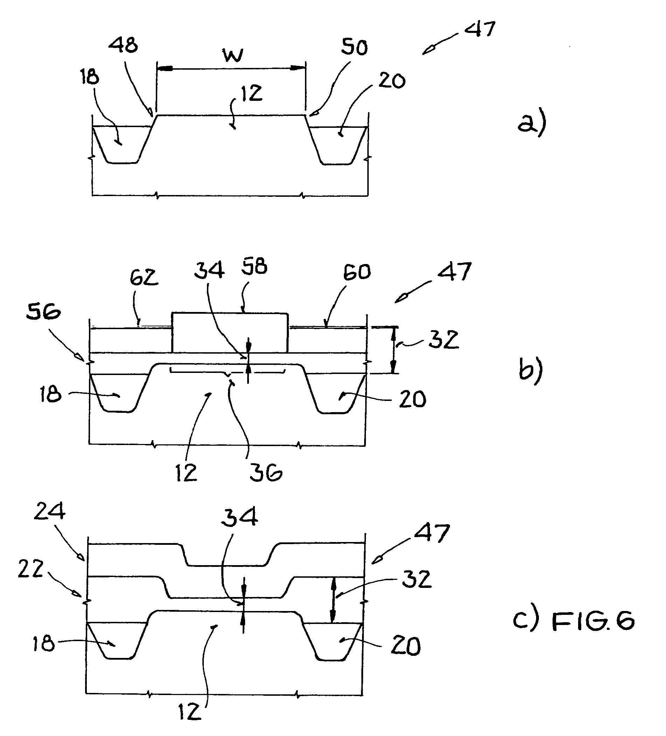

Im Folgenden werden unter Bezug auf die Figuren 5 und 6 alternative Ausgestaltungen von Herstellungsverfahren zur Herstellung von MOS-Transistorstrukturen 38 entsprechend der Figur 3 erläutert.

Figur 5a zeigt einen Querschnitt durch eine Halbleiterstruktur 47 entlang einer späteren Kanalweite W. Der Querschnitt entspricht von seiner Lage her den Querschnitten aus den Figuren 2 und 3 entlang der Linie II aus Figur 1. Entsprechend wird die Kanalweite W auch im Fall der Figur 5 durch dielektrisch gefüllte Gräben 18, 20 begrenzt. Wie bereits erläutert wurde, ergibt sich durch vorhergehende Reinigungsschritte ein verstärkter Abtrag von dielektrischem Material der Füllungen der Gräben 18 und 20, so dass im aktiven Halbleitermaterial des späteren Kanals 12 Stufen 48, 50 entstehen.

Figur 5b zeigt den die Halbleiterstruktur 47 aus der Figur 5a nach einem Schritt zur Erzeugung einer dielektrischen Schicht 52 einer ersten Dicke 32 über dem Kanalbereich 12. Wie bereits erwähnt wurde, kann die dielektrische Schicht 52 als ONO-Schicht erzeugt werden. Alternativ kann sie im Rahmen einer vorhandenen Fertigungstechnologie, die zum Beispiel für Leistungstransistoren vergleichsweise dicke dielektrische Schichten vorsieht, auch als solche Schicht erzeugt werden. Anschließend wird durch einen Lithographieschritt eine Maske 54 auf der dielektrischen Schicht 52 erzeugt und innerhalb eines zentralen Teils 36 des Kanalbereichs 12 geöffnet. Mit Hilfe der Maske 54 erfolgt in einem nachfolgenden Ätzschritt ein Abtrag von Material der dielektrischen Schicht 52 innerhalb der Öffnungen der Maske 54 hinunter bis auf die Oberfläche des aktiven Bereichs 12.

Als Resultat entsteht die in der Figur 5c dargestellte Halbleiterstruktur 47. Anschließend wird über dem zentralen Teil des aktiven Bereichs 12 die dielektrische Schicht einer zweiten Dicke 34 erzeugt, die kleiner als die erste Dicke 32 ist. Dadurch wird die in der Fig. 5d dargestellte Gate-Schicht 22 gebildet, die über einem zentralen Bereich 36 des Kanalbereichs 12 eine innere, erste Schichtdicke 34 aufweist, die kleiner als die äußere, zweite Schichtdicke 32 ist. Figur 5d zeigt die Halbleiterstruktur 47 nach der Bildung der Gate-Schicht 22 und dem daran anschließenden Abscheiden einer hoch leitfähigen Gate-Elektrode 24 auf der Gate-Schicht 22. Wie man erkennt, entspricht die Halbleiterstruktur 47 aus Figur 5d im Hinblick darauf, dass die Dicke der Gate-Schicht 22 über äußeren Teilen des Kanalbereichs 12 größer ist als über dessen zentralen Teil, dem verbesserten MOS-Transistor 38 aus Figur 3.

Beide Varianten können teilweise auch gemeinsam bei verschiedenen Bauelementen in einer Integrierten Schaltung verwendet werden. Zum Beispiel kann bei der Herstellung Integrierter Schaltungen, die Hochspannungs-DMOS-Transistoren, eingebettete E²PROM, und Niederspannungs-CMOS-Bauelemente aufweisen, und bei der eine ONO-Schicht der ersten Dicke 32 für die E²PROM-Zellen, ein dickes Gate-Oxid vergleichbarer Stärke für die DMOS-Bauelemente und eine dünnes Gate-Oxid der zweiten Dicke 34 für die Niederspannungs-CMOS-Bauelemente zur Prozessbibliothek gehört, auf die folgende Weise vorgegangen werden.

Zuerst wird die ONO-Schicht auf aktiven Bereichen einiger Bauelemente abgeschieden und strukturiert. Dabei erfolgt die Strukturierung so, dass, wie oben erläutert, ein ONO-Überlapp an den Grenzen der aktiven Bereiche auftritt, während die anderen Bauelemente vollständig von der ONO-Schicht befreit werden. Im nächsten Schritt erfolgt eine thermische Oxidation zur Herstellung des dicken Gate-Oxides und ebenfalls eine passende Strukturierung. Auch hier wird bei ausgesuchten Bauelementen ein Überlapp an Grenzen aktiver Bereiche stehengelassen. während das dicke Gate-Oxid an anderen Stellen wieder entfernt wird. Zum Abschlüss erfolgt die Bildung des dünnen Gate-Oxides auf den zentralen Teilen freiliegender aktiver Bereiche. Diese Möglichkeiten belegen die Einfachheit, mit der ein Kink oder Hump im Rahmen der hier vorgestellten Ausgestaltungen und mit einer gegebenenfalls bereits bestehenden Bibliothek von Prozessschritten vermieden werden kann.

Figur 6 zeigt ein alternatives Herstellungsverfahren, das zu einem vergleichbaren Ergebnis führt. Dabei stimmt der Ausgangszustand des Herstellungsverfahrens nach Figur 6, der in der Figur 6a dargestellt ist, mit dem Ausgangszustand des Verfahrens nach Figur 5, der in Figur 5a dargestellt ist, überein. Zur Vermeidung von Wiederholungen wird daher für ein Verständnis der Figur 6a auf die entsprechenden Erläuterungen zur Figur 5a verwiesen. Die Halbleiterstruktur 47 der Figur 6a wird mit einer dielektrischen Schicht 56 bedeckt, die über dem zentralen Teil 36 des Kanalbereichs 12 die zweite Dicke 34 der dielektrischen Gate-Schicht 22 aus Figur 3 aufweist. Anschließend wird auf dem Teil der Schicht 56, der den zentralen Teil 36 des Kanalbereichs 12 abdeckt, eine Maske 58 erzeugt. Daran schließt sich ein Vergrößern der Schichtdicken der außerhalb der Maske 58 frei liegenden dielektrischen Schicht 56 an. Dies wird in der Figur 6b durch dielektrische Schichtabschnitte 60, 62 repräsentiert, deren Gesamtdicke 32 größer ist als die zweite Dicke 34.

Daran schließt sich ein Entfemen der Maske 58 und ein Bedecken der dielektrischen Schichten 62, 56 und 60 mit einer hoch leitfähigen Gate-Elektrode 24 an. Das Ergebnis dieses Schrittes ist in der Figur 6c dargestellt, in der die Grenzflächen zwischen den dielektrischen Schichten 62 und 56 sowie 60 und 56 weggelassen worden ist. Der Querschnitt der Halbleiterstruktur 47 der Figur 6c entspricht dem Querschnitt der Halbleiterstruktur 47 der Figur 5d, so dass die Herstellungsverfahren nach den Figuren 5 und 6 zum gleichen Ergebnis führen und daher alternativ zueinander verwendet werden können. Für die Erläuterung der Figur 6c wird daher auf die entsprechende Erläuterung der Figur 5d verwiesen.

## Patentansprüche

1. Lateraler MOS-Transistor (38) mit einem Kanalbereich (12), der eine durch dielektrisch gefüllte Gräben (18, 20) begrenzte Kanalweite (W) aufweist und der durch ein Gate-Dielektrikum (22) bedeckt wird, dessen Schichtdicke über der Kanalweite (W) variiert, **dadurch gekennzeichnet, dass** eine erste Schichtdicke (32), die das Gate-Dielektrikum (22) über Übergängen des Kanalbereichs (12) zu den dielektrisch gefüllten Gräben (18, 20) besitzt, größer ist als eine zweite Schichtdicke (34), die das Dielektrikum (22) über einem zentralen Teil (36) des Kanalbereichs (12) besitzt.

2. Verfahren zur Herstellung eines lateralen MOS-Transistors (38) mit einem Kanalbereich (12), der eine durch dielektrisch gefüllte Gräben (18, 20) begrenzte Kanalweite (W) aufweist und der in einem Zwischenschritt des Verfahrens mit einem Gate-Dielektrikum (22) bedeckt wird, dessen Schichtdicke über der Kanalweite (W) variiert, **dadurch gekennzeichnet, dass** der Schritt des Bedeckens des Kanalbereichs (12) mit dem Gate-Dielektrikum (22) einen Schritt zur Erzeugung einer dielektrischen Schicht (52; 56) über dem Kanalbereich (12), einen Schritt zur lithografischen Unterscheidung eines zentralen Teils (36) des Kanalbereichs (12) von peripheren Teilen (28, 30) des Kanalbereichs (12) an Übergängen zu den dielektrischen Gräben (18, 20), und einen Schritt zur Erzeugung unterschiedlicher Schichtdicken (32, 34) des Gate-Dielektrikums (22) auf den lithografisch unterschiedenen Teilen (28, 30, 36) des Kanalbereichs (12) aufweist, bei dem sich eine über den peripheren Teilen (28, 30) einstellende erste Schichtdicke (32) größer ist als eine sich über dem zentralen Teil (36) einstellende zweite Schichtdicke (34) des Gate-Dielektrikums (22).

3. Verfahren nach Anspruch 2, **dadurch gekennzeichnet, dass** der Schritt zur Erzeugung einer dielektrischen Schicht (52; 56) über dem Kanalbereich (12) einen Schritt eines nicht-selektiven Erzeugens einer ersten Dicke (34) der dielektrischen Schicht (52) aufweist.

4. Verfahren nach Anspruch 3, **dadurch gekennzeichnet, dass** der Schritt des nicht-selektiven Erzeugens der ersten Dicke (34) einen Schritt eines Aufwachsens einer ONO-Schicht aufweist.

5. Verfahren nach Anspruch 4, **dadurch gekennzeichnet, dass** eine Oxidteilschicht der ONO-Schicht durch Abscheiden eines TEOS-Oxides gebildet wird.

6. Verfahren nach wenigstens einem der Ansprüche 3 bis 5, **gekennzeichnet durch** einen Lithografieschritt, in dem auf der dielektrischen Schicht (56) eine Maske (58) erzeugt wird und über einem zentralen Teil (36) des Kanalbereichs (12) geöffnet wird.

7. Verfahren nach Anspruch 6, **dadurch gekennzeichnet, dass** die dielektrische Schicht (52) in den geöffneten Bereichen durch einen Ätzschritt entfernt wird.

8. Verfahren nach Anspruch 7, **dadurch gekennzeichnet, dass** innerhalb der geöffneten Bereiche eine dielektrische Schicht einer zweiten Dicke (34) erzeugt wird, die kleiner als die erste Dicke (32) ist.

9. Verfahren nach Anspruch 2, **dadurch gekennzeichnet, dass** der Schritt zur Erzeugung einer dielektrischen Schicht (52; 56) über dem Kanalbereich (12) einen Schritt eines nicht-selektiven Erzeugens einer zweiten Dicke (34) der dielektrischen Schicht (56) aufweist.

10. Verfahren nach Anspruch 9, **gekennzeichnet durch** einen Lithografieschritt, in dem auf der dielektrischen Schicht (56) eine Maske (58) erzeugt wird, die außerhalb eines zentralen Teils (36) des Kanalbereichs (12) geöffnet ist, und einen weiteren Schritt, in dem die Dicke der dielektrischen Schicht (56) in geöffneten Bereichen (58) der Maske auf den Wert der ersten Dicke (32) vergrößert wird.
